# EUROPEAN PATENT APPLICATION

(11) **EP 4 383 329 A1**
(43) Date of publication of application: **12.06.2024**
(21) Application number: 22890159.1
(22) Date of filing: 08.09.2022
(51) Int. Cl.: H01L 25/075, H01L 27/15, H01L 33/48, H01L 33/08

(54) **DISPLAY MODULE AND MANUFACTURING METHOD THEREFOR**

(30) Priority: 02.11.2021 KR 20210149025; 22.12.2021 KR 20210185446
(71) Applicant: Samsung Electronics Co., Ltd., Suwon-si, Gyeonggi-do 16677 (KR)
(72) Inventor: KIM, Sungwook, Suwon-si Gyeonggi-do 16677 (KR); KIM, Sungsoo, Suwon-si Gyeonggi-do 16677 (KR); LEE, Hyunho, Suwon-si Gyeonggi-do 16677 (KR)
(74) Representative: Appleyard Lees IP LLP
(86) International application number: PCT/KR2022/013517
(87) International publication number: WO 2023/080423

(57) **Abstract**

Disclosed are a display module and a manufacturing method therefor. The disclosed display module comprises: a substrate which has provided thereon a TFT layer in which a plurality of thin film transistors (TFTs) are arranged, and has arranged thereon a plurality of substrate electrode pads electrically connected to the plurality of TFTs; a plurality of light-emitting diodes connected to the plurality of substrate electrode pads; and a driving circuit provided on the substrate, wherein the plurality of substrate electrode pads are arranged in pairs at a predetermined distance, and the plurality of light-emitting diodes may be connected to a pair of substrate electrode pads.

## Description

### [Technical Field]

The disclosure relates to a display module and a manufacturing method therefor.

### [Description of the Related Art]

In displays on which micro light-emitting diodes (referred to as micro LEDs hereinafter) are mounted that have been developed so far, one micro LED corresponds to one sub-pixel.

In case one sub-pixel consists of one micro LED, if lighting becomes impossible because the micro LED is defective or broke down, the micro LED needs to be replaced. However, as the micro LED has a micro size of 100*µ*m or smaller, replacement is difficult, and the repair cost increases due to this. This becomes a factor for increasing the unit cost of a product.

### [Detailed Description of the Invention]

### [Technical Solution]

The purpose of the disclosure is in providing a display module that is appropriate for manufacturing a display module of a large area on which micro LEDs are mounted, and that does not need repair in case the mounted micro LEDs are defective or broke down, and a manufacturing method therefor.

For achieving the aforementioned purpose, the disclosure provides a set of light-emitting diodes including a first light-emitting diode including a light-emitting surface a nd a pair of electrodes are provided on an opposite surface of the light-emitting surface, and a second light-emitting diode connected to one side of the first light-emitting diode by a connection part, wherein the thickness of the connection part is less than a thicknesse of the first light-emitting diode and a thickness of the second light-emitting diode.

Both ends of the connection part may be connected to a first side surface of the first light-emitting diode, and a second side surface of the second light-emitting diode facing the first side surface.

The connection part may be formed in a location adjacent to the light-emitting surface of the first light-emitting diode and the light-emitting surface of the second light-emitting diode.

Each of the first light-emitting diode and the second light-emitting diode may include a first semiconductor layer wherein the light-emitting surface is provided on one surface, a second semiconductor layer wherein a pair of electrode pads are arranged at an interval on one surface, and an active layer provided between the first semiconductor layer and the second semiconductor layer, and the connection part may be formed integrally with the first semiconductor layer.

Also, the disclosure can achieve the aforementioned purpose by providing a display module including a substrate wherein a TFT layer in which a plurality of thin film transistors (TFTs) are arranged is provided, and wherein a plurality of substrate electrode pads electrically connected to the plurality of TFTs are arranged, a plurality of light-emitting diodes connected to the plurality of substrate electrode pads, and a driving circuit provided on the substrate, wherein the plurality of substrate electrode pads are arranged in pairs at a predetermined distance, and the plurality of light-emitting diodes are connected to the pair of substrate electrode pads.

A first light-emitting diode and a second light-emitting diode may be connected to the pair of substrate electrode pads in a state of being separated from each other, and a first residual part and a second residual part may be formed in each side surface wherein the first light-emitting diode and the second light-emitting diode face each other.

The first residual part and the second residual part may be parts of one connection part connecting the first light-emitting diode and the second light-emitting diode, and may be divided when the one connection part is broken.

A thicknesse of the first residual part and a thickness of the second residual part may be less than a thicknesse of the first light-emitting diode and a thickness of the second light-emitting diode.

At least three light-emitting diodes may be connected to the pair of substrate electrode pads.

Also, the disclosure can achieve the aforementioned purpose by providing a method for manufacturing a display module including the steps of forming a plurality of light-emitting diodes on an epitaxial substrate, forming a plurality of light-emitting diode sets such that the plurality of light-emitting diodes are connected in a specific number, transferring the plurality of light-emitting diode sets to a display substrate, and separating the plurality of connected light-emitting diodes into each piece by pressurizing the plurality of light-emitting diode sets transferred to the display substrate.

Each of the plurality of light-emitting diode sets may include a first light-emitting diode, and a second light-emitting diode connected to a side surface of the first light-emitting diode through a connection part.

The connection part may be formed integrally with the first light-emitting diode and the second light-emitting diode.

The connection part may have a thickness that is smaller than a thickness of the first light-emitting diode and a thickness of the second light-emitting diode.

The plurality of light-emitting diode sets may be thermo-compressed to a side of the display substrate.

Each of the plurality of light-emitting diode sets may include at least three light-emitting diodes connected in a row.

### [BRIEF DESCRIPTION OF THE DRAWINGS]

FIG. 1 is a side surface view illustrating a light-emitting diode set according to an embodiment of the disclosure;
FIG. 2 is a bottom surface view illustrating a light-emitting diode set according to an embodiment of the disclosure;
FIG. 3 is a cross-sectional view illustrating the structure of one light-emitting diode among light-emitting diode sets according to an embodiment of the disclosure;
FIG. 4 is a flow chart illustrating a manufacturing process of a display module according to an embodiment of the disclosure;
FIG. 5 is a diagram illustrating an epitaxial substrate on which a first semiconductor layer, an active layer, and a second semiconductor layer are sequentially formed;
FIG. 6 is a diagram illustrating an embodiment wherein each light-emitting diode set is etched;
FIG. 7 is a diagram illustrating an embodiment wherein electrode pads are formed on a second semiconductor layer;
FIG. 8 is a diagram illustrating a relay substrate on which a plurality of light-emitting diode sets are arranged;
FIG. 9 is a diagram illustrating an embodiment wherein a laser beam is irradiated on a relay substrate arranged on the upper side of a display substrate;
FIG. 10 is a diagram illustrating an embodiment wherein light-emitting diode sets are transferred from a relay substrate to a display substrate by a laser transfer method;
FIG. 11 is a diagram illustrating an embodiment wherein a plurality of light-emitting diode sets are respectively transferred to corresponding substrate electrode pads on a display substrate;
FIG. 12 is a diagram illustrating an embodiment wherein light-emitting diode sets transferred to a display substrate are pressurized by a pressurizing member;
FIG. 13 is a diagram illustrating an embodiment wherein light-emitting diode sets are separated into each light-emitting diode;
FIG. 14 is an enlarged view illustrating the D portion displayed in FIG. 13; and
FIG. 15 is a diagram illustrating an embodiment wherein some defective light-emitting diodes among a plurality of light-emitting diodes transferred to a display substrate are not lighted.

### [Mode for Implementing the Invention]

First, terms used in this specification will be described briefly, and then the disclosure will be described in detail. Meanwhile, in describing the disclosure, detailed explanation regarding related known technologies may be omitted, and overlapping explanation of the same components will be omitted as much as possible.

Also, as terms used in the embodiments of the disclosure, general terms that are currently used widely were selected as far as possible, in consideration of the functions described in the disclosure. However, the terms may vary depending on the intention of those skilled in the art who work in the pertinent field or previous court decisions, or emergence of new technologies. Further, in particular cases, there may be terms that were designated by the applicant on his own, and in such cases, the meaning of the terms will be described in detail in the relevant descriptions in the disclosure. Accordingly, the terms used in the disclosure should be defined based on the meaning of the terms and the overall content of the disclosure, but not just based on the names of the terms.

In addition, various modifications may be made to the embodiments of the disclosure, and there may be various types of embodiments. Accordingly, specific embodiments will be illustrated in drawings, and the embodiments will be described in detail in the detailed description. However, it should be noted that the various embodiments are not for limiting the scope of the disclosure to a specific embodiment, but they should be interpreted to include all modifications, equivalents, or alternatives of the embodiments included in the ideas and the technical scopes disclosed herein. Meanwhile, in case it is determined that in describing embodiments, detailed explanation of related known technologies may unnecessarily confuse the gist of the disclosure, the detailed explanation will be omitted.

Further, in the disclosure, terms such as 'the first,' 'the second,' and 'the third' may be used to describe various elements, but the terms are not intended to limit the elements. The terms may be used only for the purpose of distinguishing one element from another element. For example, a first element may be called a second element, and a second element may be called a first element in a similar manner, without departing from the scope of the disclosure.

Also, in the disclosure, singular expressions include plural expressions, unless defined obviously differently in the context. Further, in the disclosure, terms such as "include" or "consist of" should be construed as designating that there are such characteristics, numbers, steps, operations, elements, components, or a combination thereof described in the specification, but not as excluding in advance the existence or possibility of adding one or more of other characteristics, numbers, steps, operations, elements, components, or a combination thereof.

In addition, in the disclosure, "a module" or "a part" performs at least one function or operation, and may be implemented as hardware or software, or as a combination of hardware and software. Also, a plurality of "modules" or "parts" may be integrated into at least one module and implemented as at least one processor, except "a module" or "a part" that needs to be implemented as specific hardware.

A display module according to an embodiment of the disclosure may include a display panel. The display panel is a kind of flat display panel, and on the display panel, a plurality of inorganic light-emitting diodes (LEDs) each of which is 100*µ*m or smaller may be arranged. A display module on which micro LEDs are mounted provides better contrast, response time, and energy efficiency than a liquid crystal display (LCD) panel which needs a backlight. Also, organic light-emitting diodes (OLEDs) and micro LEDs which are inorganic light-emitting diodes all have good energy efficiency, but micro LEDs have better brightness and light emitting efficiency, and a longer lifespan than OLEDs. Micro LEDs may be a semiconductor chip that can emit a light by itself in case power is supplied. Micro LEDs have fast response speed, low power consumption, and high luminance. For example, micro LEDs have higher efficiency in converting electricity into photons than an LCD or OLEDs. For example, micro LEDs have higher "brightness per watt" than an LCD or an OLED display. Accordingly, micro LEDs can exert identical brightness with about half the energy compared to conventional LEDs (of which length, width, and height respectively exceed 100µm) or OLEDs. Further, micro LEDs can implement a high resolution, excellent colors, contrast, and brightness, and thus they can express colors in a wide range correctly, and can implement a clear screen in the outdoors wherein sunlight is bright. Also, micro LEDs are strong against a burn-in phenomenon and generate little heat, and thus a long lifespan without distortion is guaranteed. Micro LEDs may have a flip chip structure wherein an anode electrode and a cathode electrode are formed on the same first surface, and a light emitting surface is formed on a second surface positioned on the opposite side of the first surface wherein the electrode terminals are formed.

The plurality of micro LEDs may consist of one light-emitting diode set connected in a row. In this case, light-emitting diode sets adjacent to each other may be connected by a connection part.

The light-emitting diode sets may be electrically and physically connected to a plurality of substrate electrode pads arranged on a display substrate through a thermo-compression process after being transferred to the display substrate. The light-emitting diode sets receive pressure at the time of thermo-compression. In this case, if the connection parts connecting the light-emitting diodes adjacent to each other are cut off(broken) by the pressure, the plurality of light-emitting diodes connected in a row by the connection parts may be separated independently.

One pixel may include a plurality of light-emitting diode sets. That is, one light-emitting diode set may constitute one sub-pixel. For example, light-emitting diodes constituting a first light-emitting diode set may emit a light of a red wavelength band. Light-emitting diodes constituting a second light-emitting diode set may emit a light of a green wavelength band. Light-emitting diodes constituting a third light-emitting diode set may emit a light of a blue wavelength band.

On a glass substrate, a TFT layer on which a thin film transistor (TFT) circuit is formed may be arranged on the front surface, and a driving circuit for driving the TFT circuit may be arranged on the rear surface. The TFT circuit may drive a plurality of pixels arranged on the TFT layer.

The front surface of the glass substrate may be divided into an active area and an inactive area. The active area may correspond to an area occupied by the TFT layer on the front surface of the glass substrate, and the inactive area may be an area excluding the area occupied by the TFT layer on the front surface of the glass substrate.

The edge area of the glass substrate may be the outermost area of the glass substrate. Also, the edge area of the glass substrate may be the remaining area excluding the area wherein the circuit of the glass substrate is formed. In addition, the edge area of the glass substrate may include a side surface of the glass substrate, and a portion of the front surface of the glass substrate and a portion of the rear surface of the glass substrate adjacent to the side surface. The glass substrate may be formed as a quadrangle type. Specifically, the glass substrate may be formed as a rectangle or a square. The edge area of the glass substrate may include at least one side among the four sides of the glass substrate.

The display module includes a glass substrate on which a plurality of LEDs are mounted and a side surface wiring is formed. Such a display module may be installed and applied in a single unit on wearable devices, portable devices, handheld devices, and various kinds of electronic products or electronic components which need displays. Also, the display module may be applied as a matrix type to display devices such as monitors for personal computers (PCs), high resolution TVs and signage (or, digital signage), and electronic displays through a plurality of assembly arrangements.

Hereinafter, the embodiments of the disclosure will be described in detail with reference to the accompanying drawings, such that those having ordinary skill in the art to which the disclosure belongs can easily carry out the disclosure. However, it should be noted that the disclosure may be implemented in various different forms, and is not limited to the embodiments described herein. Also, in the drawings, parts that are not related to explanation were omitted, for explaining the disclosure clearly, and throughout the specification, similar components were designated by similar reference numerals.

Further, while the embodiments of the disclosure will be described in detail with reference to the following accompanying drawings and the content described in the accompanying drawings, it is not intended that the disclosure is restricted or limited by the embodiments.

Hereinafter, light-emitting diodes and a display module including the same according to an embodiment of the disclosure will be described with reference to the drawings.

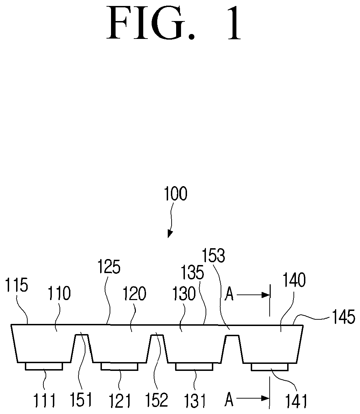

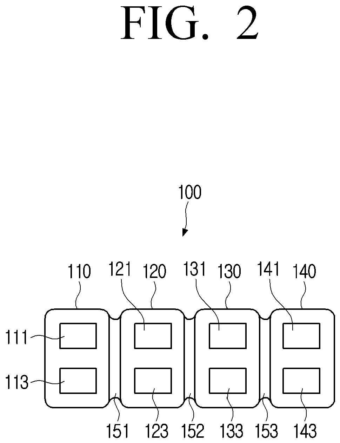

FIG. 1 is a side surface view illustrating a light-emitting diode set according to an embodiment of the disclosure, and FIG. 2 is a bottom surface view illustrating a light-emitting diode set according to an embodiment of the disclosure.

Referring to FIG. 1 and FIG. 2, a light-emitting diode set 100 according to an embodiment of the disclosure may include first to fourth light-emitting diodes 110, 120, 130, 140 connected by first to third connection parts 151, 152, 153.

It is described that the light-emitting diode set 100 includes the four light-emitting diodes 110, 120, 130, 140, but the disclosure is not limited thereto. For example, the light-emitting diode set 100 may include at least two light-emitting diodes connected by the connection part.

The first to fourth light-emitting diodes 110, 120, 130, 140 may be inorganic light-emitting diodes having a size of 100*µ*m or smaller. For example, they may be mini LEDs or micro LEDs.

The first to fourth light-emitting diodes 110, 120, 130, 140 may be connected in a row by the first to third connection parts 151, 152, 153. For example, the first light-emitting diode 110 and the second light-emitting diode 120 may be connected to each other by the first connection part 151, the second light-emitting diode 120 and the third light-emitting diode 130 may be connected to each other by the second connection part 152, and the third light-emitting diode 130 and the fourth light-emitting diode 140 may be connected to each other by the third connection part 153.

The first to third connection parts 151, 152, 153 may be located on the side surfaces of the first to fourth light-emitting diodes 110, 120, 130, 140 adjacent to the light-emitting surfaces 115, 125, 135, 145 of the first to fourth light-emitting diodes 110, 120, 130, 140.

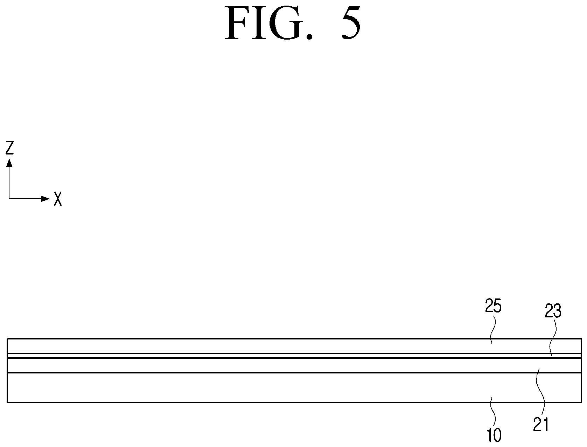

The first to third connection parts 151, 152, 153 may be a part of a first semiconductor layer 21 (refer to FIG. 5) that is formed on an epitaxial substrate 10 (refer to FIG. 5) when the first to fourth light-emitting diodes 110, 120, 130, 140 are grown on the epitaxial substrate 10.

The first to third connection parts 151, 152, 153 may be cut off(broken) by the pressure applied to the light-emitting diode set 100 in a thermo-compression process after transferring the light-emitting diode set 100 to a display substrate 70.

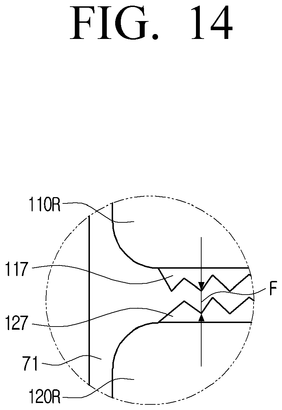

Accordingly, the connection of the first to fourth light-emitting diodes 110, 120, 130, 140 by the first to third connection parts 151, 152, 153 may be released, and they may get in a state of being separated from each other. In this case, parts of the first connection part 151 may remain in a form of respectively protruding from the side surface of the first light-emitting diode 110 and the side surface of the second light-emitting diode 120 (refer to FIG. 14).

Parts of the second and third connection parts 152, 153 may remain in a form of respectively protruding from the side surface of the second light-emitting diode 120 and the side surface of the third light-emitting diode 130, and the side surface of the third light-emitting diode 130 and the side surface of the fourth light-emitting diode 140 in a cut-off state, like the first connection part 151.

The first to fourth light-emitting diodes 110, 120, 130, 140 are inorganic light-emitting diodes, and they may be micro LEDs having a size of 100,um or smaller. As the structures of the first to fourth light-emitting diodes 110, 120, 130, 140 are substantially identical, only the structure of the first light-emitting diode 110 will be described hereinafter.

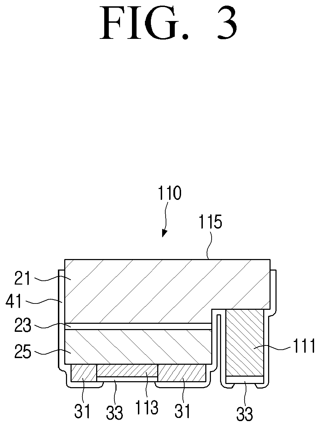

FIG. 3 is a cross-sectional view illustrating the structure of one light-emitting diode among light-emitting diode sets according to an embodiment of the disclosure.

Referring to FIG. 3, the first light-emitting diode 110 may include a first semiconductor layer 21 and a second semiconductor layer 25 grown on the epitaxial substrate 10 (refer to FIG. 5), and an active layer 23 arranged between the first semiconductor layer 21 and the second semiconductor layer 25.

The first semiconductor layer 21 may include, for example, a p-type semiconductor layer. The p-type semiconductor layer may be selected, for example, from GaN, AlN, AlGaN, InGaN, InN, InAlGaN, AlInN, etc., and a p-type dopant such as Mg, Zn, Ca, Sr, Ba, etc. may be doped on it.

The second semiconductor layer 25 may include, for example, an n-type semiconductor layer. The n-type semiconductor layer may be selected, for example, from GaN, AlN, AlGaN, InGaN, InN, InAlGaN, AlInN, etc., and an n-type dopant such as Si, Ge, Sn, etc. may be doped on it.

The active layer 23 is an area wherein electrons and holes are re-coupled, and the layer transits to a lower energy level as electrons and holes are re-coupled, and may generate a light having a wavelength corresponding thereto. The active layer 23 may include a semiconductor material, e.g., amorphous silicon or poly crystalline silicon. However, embodiments of the disclosure are not limited thereto, and the active layer 23 may include an organic semiconductor material, etc., and may be formed in a single quantum well (SQW) structure or a multi quantum well (MQW) structure.

The epi-grown parts of the first light-emitting diode 110 are not limited to the aforementioned structure. For example, the first semiconductor layer 21 may include an n-type semiconductor layer, and the second semiconductor layer 25 may include a p-type semiconductor layer.

The first light-emitting diode 110 may have a flip chip structure wherein the first electrode 111 and the second electrode 113 are arranged on the opposite surface of the light-emitting surface 115.

The first electrode 111 is an n-type electrode, and may be electrically connected to the first semiconductor layer 21, and may consist of any one of Al, Ti, Cr, Ni, Pd, Ag, Ge, and Au, or an alloy thereof. In this case, an electrical conductive oxide such as indium tin oxide (ITO) and ZnO may be used for ohmic contacts between the first electrode 111 and the first semiconductor layer 21.

The second electrode 113 is a p-type electrode, and may be electrically connected to the second semiconductor layer 25, and may consist of any one of Al, Ti, Cr, Ni, Pd, Ag, Ge, and Au, or an alloy thereof. In this case, an electrical conductive oxide such as indium tin oxide (ITO) and ZnO may be used for ohmic contacts between the second electrode 113 and the second semiconductor layer 25.

The first light-emitting diode 110 may include an insulation layer 31 laminated on one surface of the second semiconductor layer 25 to surround the second electrode 113, a metal cap 33 covering the exposed first and second electrodes 111, 113 for preventing oxidation of the first and second electrodes 111, 113, and a passivation layer 41 covering the side surface and the lower part of the first light-emitting diode 110 for protecting the first light-emitting diode 110. In this case, the passivation layer 41 may cover the lower part of the first light-emitting diode 110 such that the metal cap 33 is exposed. The material of the passivation layer 41 may consist of, for example, SiO₂.

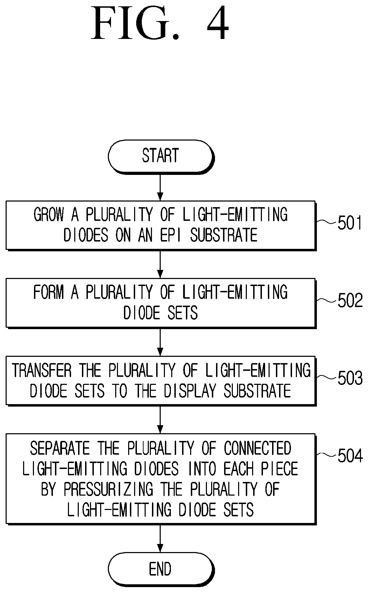

Hereinafter, a method for manufacturing a display module according to an embodiment of the disclosure will be described with reference to FIG. 4 to FIG. 15.

FIG. 4 is a flow chart illustrating a manufacturing process of a display module according to an embodiment of the disclosure, and FIG. 5 is a diagram illustrating an epitaxial substrate on which a first semiconductor layer, an active layer, and a second semiconductor layer are sequentially formed.

Referring to FIG. 5, the first semiconductor layer 21, the active layer 23, and the second semiconductor layer 25 are grown on the epitaxial substrate 10. Each of the first conductive semiconductor layer 121, the active layer 122, and the second conductive semiconductor layer 123 may grow into a group III-V compound semiconductor material, and as a representative example, a GaN material may be used. Such growth may be performed by metal organic chemical vapor deposition (MOCVD).

For reducing a crystalline defect according to the difference in the lattice constant between the epitaxial substrate 10 and the first semiconductor layer 21, a buffer layer (not shown) consisting of an AlN layer (or a GaN layer)/an undoped GaN layer may be formed on the epitaxial substrate 10 first, and then the plurality of light-emitting diodes 110, 120, 130, 140 may be grown (501).

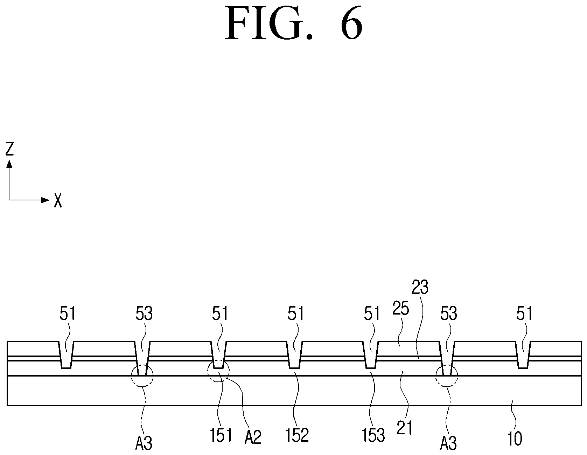

FIG. 6 is a diagram illustrating an embodiment wherein each light-emitting diode set is etched.

Referring to FIG. 6, the first semiconductor layer 21, the active layer 23, and the second semiconductor layer 25 may be isolated in units of light-emitting diodes through a mesa etching process.

In the mesa etching process, a first etching groove 51 having a different depth from each other, and a second etching groove 53 having a deeper depth than the depth of the first etching groove 51 may be formed on the first semiconductor layer 21, the active layer 23, and the second semiconductor layer 25.

For example, the first etching groove 51 is formed from the second semiconductor layer 25 to the first semiconductor layer 21 via the active layer 23. In this case, the first etching groove 51 may not penetrate the first semiconductor layer 21 completely, but may be formed to have a depth that makes a part of the first semiconductor layer 21 (e.g., the connection part 151) remain as in the A2 part in FIG. 6. A part of the first semiconductor layer 21 (e.g., the connection part 151) corresponds to the first connection part 151 connecting the first light-emitting diode 110 and the second light-emitting diode 120. Regarding the depth of the first etching groove 51, consideration may be made such that the plurality of light-emitting diodes constituting the light-emitting diode set 100 are partitioned, and the light-emitting diodes are connected in a row without being separated completely.

The second etching groove 53 is formed from the second semiconductor layer 25 to the first semiconductor layer 21 via the active layer 23. In this case, the second etching groove 53 may penetrate the first semiconductor layer 21 completely, and may be formed to have a depth that the upper surface of the epitaxial substrate can be exposed. Regarding the depth of the second etching groove 53, consideration may be made such that the groove can be partitioned into units of a plurality of light-emitting diode sets.

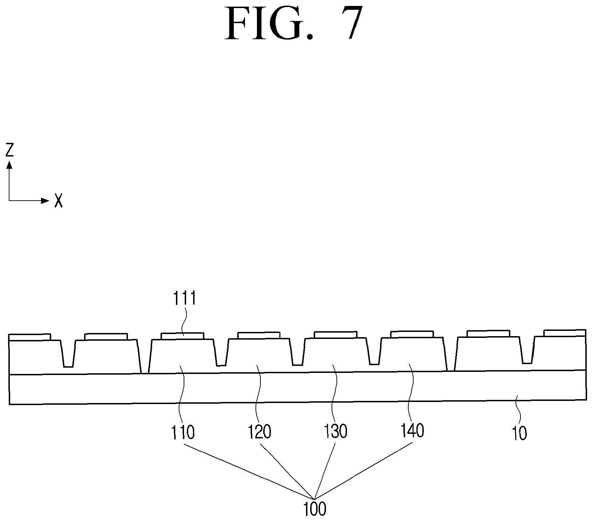

FIG. 7 is a diagram illustrating an embodiment wherein electrode pads are formed on a second semiconductor layer.

Referring to FIG. 7, on each light-emitting diode, a first electrode 111 connected to the first semiconductor layer 21, and a second electrode 113 connected to the second semiconductor layer 25 are formed (refer to FIG. 5). Also, on each light-emitting diode, an insulation layer 31 laminated on one surface of the second semiconductor layer 25 to surround the second electrode 113, a metal cap 33 covering the exposed first and second electrodes 111, 113 for preventing oxidation of the first and second electrodes 111, 113, and a passivation layer 41 covering the side surface and the lower part of the first light-emitting diode 110 for protecting the first light-emitting diode 110 may be sequentially formed.

As described above, a plurality of light-emitting diode sets 100 separated into each light-emitting diode set are formed on the epitaxial substrate 10 (502).

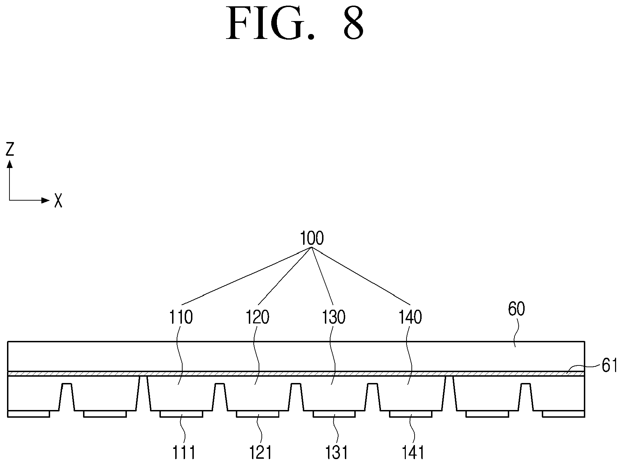

FIG. 8 is a diagram illustrating a relay substrate on which a plurality of light-emitting diode sets are arranged.

Referring to FIG. 8, the plurality of light-emitting diode sets 100 on the epi substrate 10 are transferred from the epitaxial substrate 10 to a relay substrate 60 by a laser lift-off (LLO) method.

In this case, in the plurality of light-emitting diode sets 100, the light-emitting surfaces 115 (refer to FIG. 5) of each light-emitting diode 110, 120, 130, 140 may be attached to the relay substrate 60 by an adhesion layer 61.

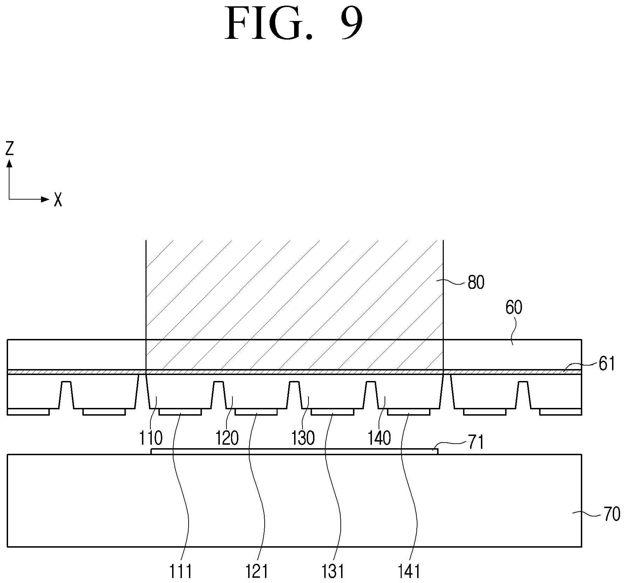

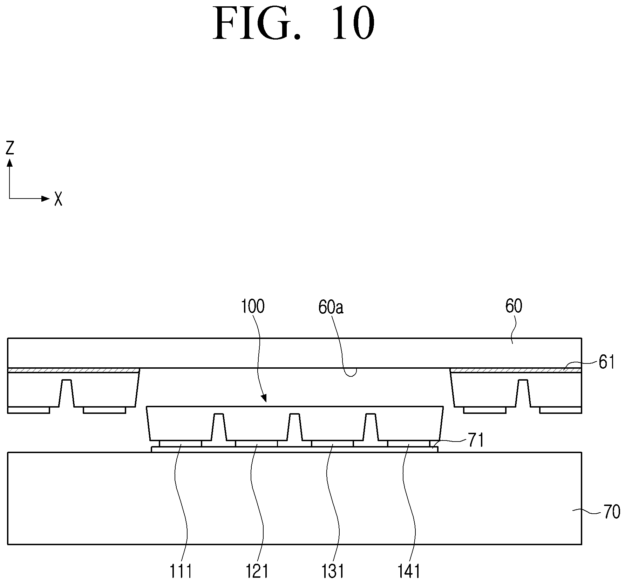

FIG. 9 is a diagram illustrating an embodiment wherein a laser beam is irradiated on a relay substrate arranged on the upper side of a display substrate, and FIG. 10 is a diagram illustrating an embodiment wherein light-emitting diode sets are transferred from a relay substrate to a display substrate by a laser transfer method.

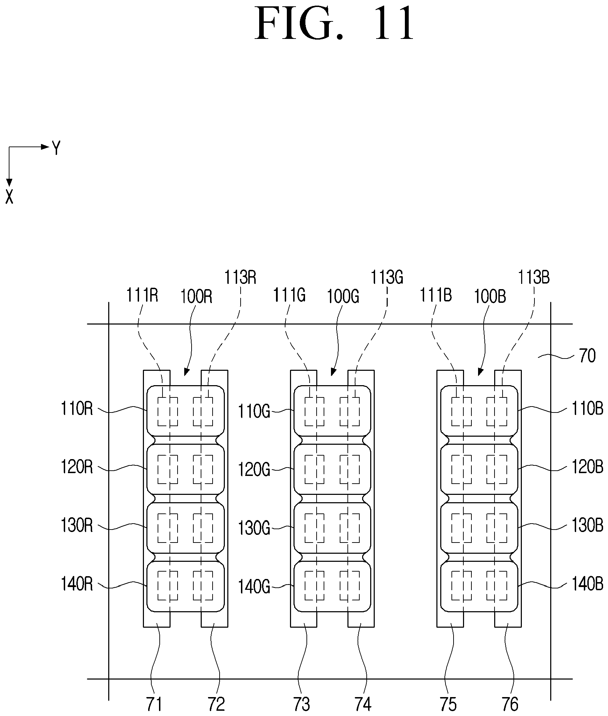

Referring to FIG. 9, the relay substrate 60 is arranged on the upper side of the display substrate 70 to face the display substrate 70. In this case, with respect to the light-emitting diode sets 100 attached to the relay substrate 60, the relay substrate 60 and the display substrate 70 may be aligned such that the first and second electrodes 111, 113 of each light-emitting diode 110, 120, 130, 140 correspond to the substrate electrode pads 71, 72 (refer to FIG. 11) arranged on the upper surface of the display substrate 70.

In a state wherein the relay substrate 60 and the display substrate 70 are aligned, a laser beam 80 is irradiated on a predetermined area with respect to the relay substrate 60. Here, the area on which the laser beam 80 is irradiated in the relay substrate 60 is the area wherein the light-emitting diode sets 100 to be transferred to the display substrate 70 are arranged.

Meanwhile, on the upper surface of the display substrate 70, an adhesion layer (not shown) may be coated such that the first and second electrodes 111, 113 of the light-emitting diode sets 100 can be steadfastly fixed to the first and second substrate electrode pads 71, 72. In this case, the adhesion layer may be an anisotropic conductive film (ACF) or a non-conductive film (NCF).

Referring to FIG. 10, the plurality of light-emitting diode sets 100 attached to the relay substrate 60 are transferred to the display substrate 70 by a laser transfer method (503).

FIG. 11 is a diagram illustrating an embodiment wherein a plurality of light-emitting diode sets are respectively transferred to corresponding substrate electrode pads on a display substrate.

Referring to FIG. 11, the plurality of red, green, and blue light-emitting diode sets 100R, 100G, 100B may be sequentially transferred to the display substrate 70 for each light-emitting color.

For example, the red light-emitting diode set 100R arranged on the first relay substrate is transferred to each pixel area of the display substrate 70. Then, the green light-emitting diode set 100G arranged on the second relay substrate is transferred to each pixel area of the display substrate 70. Then, the blue light-emitting diode set 100B arranged on the third relay substrate is transferred to each pixel area of the display substrate 70.

Accordingly, as in FIG. 11, in one pixel area, the red light-emitting diode set 100R, the green light-emitting diode set 100G, and the blue light-emitting diode set 100B which are sub-pixels in different colors from one another may be arranged.

The light-emitting diodes 110R, 120R, 130R, 140R constituting the red light-emitting diode set 100R may emit a light of a red wavelength band. The light-emitting diodes 110G, 120G, 130G, 140G constituting the green light-emitting diode set 100G may emit a light of a green wavelength band. The light-emitting diodes 110B, 120B, 130B, 140B constituting the blue light-emitting diode set 100B may emit a light of a blue wavelength band.

In this case, the first substrate electrode pad 71 and the second substrate electrode pad 72 corresponding to the red light-emitting diode set 100R may be constituted in a specific length such that each of the first electrodes and the second electrodes of the light-emitting diodes 110R, 120R, 130R, 140R can be electrically connected.

Likewise, the first substrate electrode pads 73, 75 and the second substrate electrode pads 74, 76 corresponding to the green light-emitting diode set 100G and the blue light-emitting diode set 100B may be constituted in a specific length such that each of the first electrodes and the second electrodes of the light-emitting diodes 110G, 120G, 130G, 140G; 110B, 120B, 130B, 140B can be electrically connected.

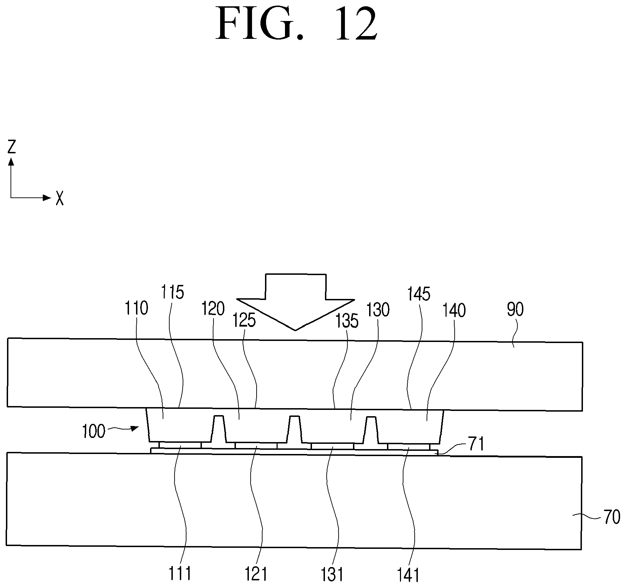

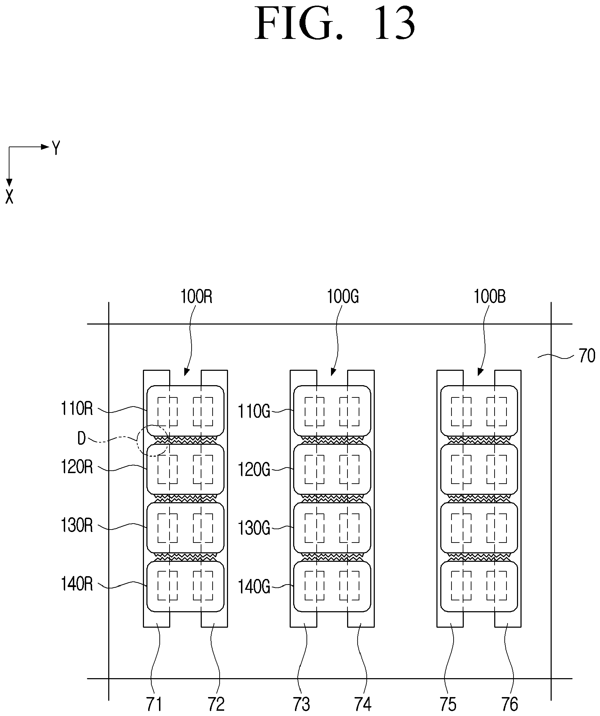

FIG. 12 is a diagram illustrating an embodiment wherein light-emitting diode sets transferred to a display substrate are pressurized by a pressurizing member, FIG. 13 is a diagram illustrating an embodiment wherein light-emitting diode sets are separated into each light-emitting diode, and FIG. 14 is an enlarged view illustrating the D portion displayed in FIG. 13.

A thermo-compression process proceeds for the plurality of light-emitting diode sets 100 transferred to the display substrate 70 such that the first and second electrodes 111, 113 of each light-emitting diode 110, 120, 130, 140 can be steadfastly fixed to the corresponding first and second substrate electrode pads 71, 72 by the adhesion layer of the display substrate 70.

Referring to FIG. 12, the plurality of light-emitting diode sets 100R, 100G, 100B may be pressurized by specific pressure to the side of the display substrate 70 by a pressurizing member 90.

Referring to FIG. 13, in the red light-emitting diode set 100R, the first to third connection parts 151, 152, 153 (refer to FIG. 2) connecting the plurality of light-emitting diodes 110R, 120R, 130R, 140R with one another are easily cut off due to the pressure by the pressurizing member 90. Accordingly, each of the plurality of light-emitting diodes 110R, 120R, 130R, 140R can be separated independently (504).

In the green light-emitting diode set 100G and the blue light-emitting diode set 100B, as the first to third connection parts connecting each light-emitting diode 110G, 120G, 130G, 140G; 110B, 120B, 130B, 140B are cut off, each light-emitting diode 110G, 120G, 130G, 140G; 110B, 120B, 130B, 140B can be separated.

In this case, referring to FIG. 14, a part 117 of the first connection part 151 (refer to FIG. 2) may remain in a form of protruding from the side surface of the first light-emitting diode 110R, and another part 127 of the first connection part 151 may remain in a form of protruding from the side surface of the second light-emitting diode 120R, respectively. Likewise, a part and another part of the cut-off second and third connection parts 152, 153 (refer to FIG. 2) may remain in a form of protruding from the side surface of the second light-emitting diode 120R and the side surface of the third light-emitting diode 130R, and the side surface of the third light-emitting diode 130R and the side surface of the fourth light-emitting diode 140R, respectively.

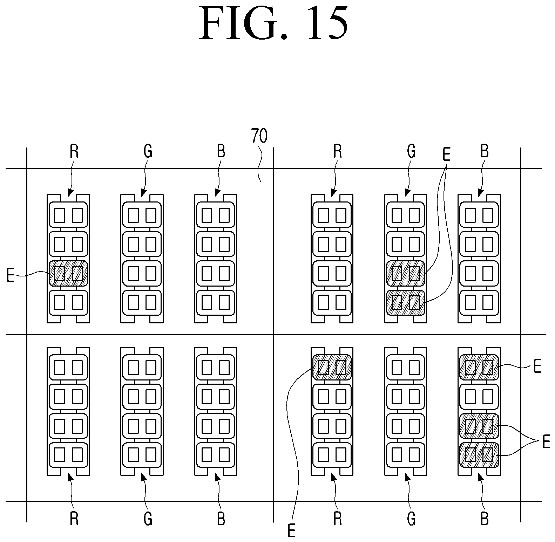

FIG. 15 is a diagram illustrating an embodiment wherein some defective light-emitting diodes among a plurality of light-emitting diodes transferred to a display substrate are not lighted. In FIG. 15, a part and another part of the connection parts that remain on the side surfaces of each light-emitting diode will be omitted, for the convenience of explanation.

Referring to FIG. 15, some light-emitting diodes E among the plurality of light-emitting diodes R, G, B transferred to the display substrate 70 may not be lighted due to defects.

In this case, as one sub-pixel consists of a plurality of light-emitting diodes, even if one or more defective light-emitting diodes are generated, the remaining light-emitting diodes are connected stably, and thus light emission of high efficiency can be expected without a repair process.

While preferred embodiments of the disclosure have been shown and described, the disclosure is not limited to the aforementioned specific embodiments, and it is apparent that various modifications may be made by those having ordinary skill in the technical field to which the disclosure belongs, without departing from the gist of the disclosure as claimed by the appended claims. Further, it is intended that such modifications are not to be interpreted independently from the technical idea or prospect of the disclosure.

## Claims

1. A set of light-emitting diodes comprising:
a first light-emitting diode comprising a light-emitting surface and a pair of electrodes are provided on opposite surface of the light-emitting surface; and
a second light-emitting diode connected to one side of the first light-emitting diode by a connection part,
wherein the thickness of the connection part is less than a thicknesse of the first light-emitting diode and a thickness of the second light-emitting diode.

2. The set of light-emitting diodes of claim 1,
wherein the connection part is connected to a first side surface of the first light-emitting diode, and a second side surface of the second light-emitting diode facing the first side surface of the first light-emitting diode.

3. The set of light-emitting diodes of claim 2,
wherein the connection part is formed in a location adjacent to the light-emitting surface of the first light-emitting diode and the light-emitting surface of the second light-emitting diode.

4. The set of light-emitting diodes of claim 2,
wherein each of the first light-emitting diode and the second light-emitting diode comprises:
a first semiconductor layer wherein the light-emitting surface is provided on one surface;
a second semiconductor layer wherein a pair of electrode pads are arranged at an interval on one surface; and
an active layer provided between the first semiconductor layer and the second semiconductor layer, and
the connection part is formed integrally with the first semiconductor layer.

5. A display module comprising:
a substrate wherein a TFT layer in which a plurality of thin film transistors (TFTs) are arranged is provided, and wherein a plurality of substrate electrode pads electrically connected to the plurality of TFTs are arranged;
a plurality of light-emitting diodes connected to the plurality of substrate electrode pads; and
a driving circuit provided on the substrate,
wherein the plurality of substrate electrode pads are arranged in pairs at a predetermined distance, and
the plurality of light-emitting diodes are connected to the pair of substrate electrode pads.

6. The display module of claim 5,
wherein a first light-emitting diode and a second light-emitting diode are connected to the pair of substrate electrode pads in a state of being separated from each other, and
a first residual part and a second residual part are formed in each side surface wherein the first light-emitting diode and the second light-emitting diode face each other.

7. The display module of claim 6,
wherein the first residual part and the second residual part are parts of one connection part connecting the first light-emitting diode and the second light-emitting diode, and are divided when the one connection part is broken.

8. The display module of claim 6,
wherein a thickness of the first residual part and a thickness of the second residual part are less than a thickness of the first light-emitting diode and a thickness of the second light-emitting diode.

9. The display module of claim 5,
wherein al least three light-emitting diodes are connected to the pair of substrate electrode pads.

10. A method for manufacturing a display module, the method comprising:
forming a plurality of light-emitting diodes on an epitaxial substrate;
forming a plurality of light-emitting diode sets such that the plurality of light-emitting diodes are connected in a specific number;
transferring the plurality of light-emitting diode sets to a display substrate; and
separating the plurality of connected light-emitting diodes into each piece by pressurizing the plurality of light-emitting diode sets transferred to the display substrate.

11. The method for manufacturing a display module of claim 10,
wherein each of the plurality of light-emitting diode sets comprises a first light-emitting diode, and a second light-emitting diode connected to a side surface of the first light-emitting diode through a connection part.

12. The method for manufacturing a display module of claim 11,
wherein the connection part is formed integrally with the first light-emitting diode and the second light-emitting diode.

13. The method for manufacturing a display module of claim 11,
wherein the connection part has a thickness that is smaller than a thickness of the first light-emitting diode and a thickness of the second light-emitting diode.

14. The method for manufacturing a display module of claim 11,
wherein the plurality of light-emitting diode sets are thermo-compressed to a side of the display substrate.

15. The method for manufacturing a display module of claim 10,
wherein each of the plurality of light-emitting diode sets comprises at least three light-emitting diodes connected in a row.
